# EUROPÄISCHE PATENTSCHRIFT

(11) **EP 2 517 318 B1**
(45) Veröffentlichungstag und Bekanntmachung des Hinweises auf die Patenterteilung: **20.12.2017**
(21) Anmeldenummer: 10805204.4
(22) Anmeldetag: 21.12.2010
(51) Int. Cl.: H01S 3/0941, G02B 27/09, H01S 5/00, H01S 5/40, G02B 19/00

(54) **OPTISCHE ANORDNUNG ZUM OPTISCHEN PUMPEN EINES AKTIVEN MEDIUMS**
OPTICAL ASSEMBLY FOR OPTICALLY PUMPING AN ACTIVE MEDIUM
AGENCEMENT OPTIQUE POUR LE POMPAGE OPTIQUE D'UN MILIEU ACTIF

(30) Priorität: 21.12.2009 DE 102009059894
(43) Veröffentlichungstag der Anmeldung: 31.10.2012
(73) Patentinhaber: Fraunhofer-Gesellschaft zur Förderung der angewandten Forschung e.V., 80686 München (DE); Rheinisch-Westfälische Technische Hochschule Aachen (RWTH), 52062 Aachen (DE)
(72) Erfinder: SCHNITZLER, Claus, 52072 Aachen (DE)
(74) Vertreter: Gagel, Roland
(86) Internationale Anmeldenummer: PCT/EP2010/007850
(87) Internationale Veröffentlichungsnummer: WO 2011/085794

(56) Entgegenhaltungen:
- WO-A1-2008/017286
- US-A1- 2004 156 130
- US-A1- 2008 084 612
- KOHLER B ET AL: "11 kW direct diode laser system with homogenized 55 * 20 mm<2> top-hat intensity distribution", PROCEEDINGS OF THE SPIE - THE INTERNATIONAL SOCIETY FOR OPTICAL ENGINEERING SPIE - THE INTERNATIONAL SOCIETY FOR OPTICAL ENGINEERING USA, Bd. 6456, 22. Januar 2007 (2007-01-22), Seiten 64560O-1-64560O-12, XP040235191, San Jose, CA, USA ISSN: 0277-786X, DOI: 10.1117/12.698837
- HUANG F ET AL: "Laser diode end-pumped efficient coupling system based on microlens arrays", PROCEEDINGS OF SPIE - THE INTERNATIONAL SOCIETY FOR OPTICAL ENGINEERING - 2009 INTERNATIONAL CONFERENCE ON OPTICAL INSTRUMENTS AND TECHNOLOGY - OPTICAL SYSTEMS AND MODERN OPTOELECTRONIC INSTRUMENTS 2009 SPIE USA, Bd. 7506, 19. Oktober 2009 (2009-10-19), XP040504321, DOI: DOI:10.1117/12.837356

## Beschreibung

### Technisches Anwendungsgebiet

Die vorliegende Erfindung betrifft eine optische Anordnung zum optischen Pumpen eines aktiven Mediums, mit der eine Symmetrisierung und/oder Homogenisierung einer Orts- und Winkelverteilung optischer Strahlung einer zum Pumpen eingesetzten Lichtquelle, insbesondere einer Laserlichtquelle, erreicht wird.

Optische Anordnungen zur Symmetrisierung und/oder Homogenisierung optischer Strahlung werden im Bereich der Lasertechnik eingesetzt, um die Intensitätsverteilung eines Laserstrahlbündels zu symmetrisieren oder zu homogenisieren, d.h. insbesondere inhomogene Intensitätsverteilungen, wie sie z.B. durch Emitterdegradation oder Ausfall bei Diodenlasern entstehen, zu kompensieren. Symmetrisierte und/oder homogenisierte Laserstrahlung wird beispielsweise zum optischen Pumpen von aktiven Medien oder zur Materialbearbeitung benötigt.

Für die optische Anregung von Lasermedien werden zunehmend Diodenlaser eingesetzt. Die Form des aktiven Mediums, insbesondere dessen Querschnittsgeometrie, gibt dabei die optimale Verteilung der Pumplaserstrahlung vor. Im Falle von quaderförmigen Laserkristallen (Slab-Kristallen) ist die Geometrie eher linienförmig, bei Scheiben- bzw. Faserlasern eher rotationssymmetrisch. Dabei ist in nahezu allen Fällen eine homogene Lichtverteilung wünschenswert. Da die Absorption der Pumplaserstrahlung nicht auf eine Ebene begrenzt ist, sondern die Absorptionslänge in der Größenordnung einiger Millimeter liegt, kommt nicht nur der Ortsverteilung der Intensität am Eintritt in das aktive Medium sondern auch im weiteren Verlauf im aktiven Medium eine wichtige Rolle zu.

### Stand der Technik

Die Homogenisierung von Diodenlaserstrahlung erfolgt bisher entweder in speziell ausgelegten Glashomogenisatoren (Stäbe oder Quader), die durch Totalreflexion eine Durchmischung der Strahlung erzielen, oder durch Einsatz von Mikrolinsenarrays. Beim Einsatz von Mikrolinsenarrays erfolgt zunächst eine Zerteilung (Segmentierung) des Strahlenbündels durch das Mikrolinsenarray, um anschließend durch Neuanordnung der einzelnen Segmente mit Hilfe einer Abbildungsoptik eine homogene Verteilung zu erzeugen. Die Verwendung von Glasquadern zur Homogenisierung führt jedoch zu großvolumigen Aufbauten, wobei die Homogenisatoren aufwendig gefertigte Komponenten sind. Insbesondere bei Diodenlasern mit Wellenlängen um 938 nm ist nur OH-freies Material verwendbar, das extrem teuer ist.

Aus dem SMO TechInfo Sheet 10 der SÜSS MicroOptics SA, Januar 2008, sind Anordnungen bekannt, die Mikrolinsenarrays zur Strahlhomogenisierung einsetzen. Hierbei wird das Eingangsstrahlbündel durch ein einfaches oder doppeltes Mikrolinsenarray in einzelne Teilstrahlenbündel aufgeteilt, die dann mit einer Abbildungsoptik in die Brenn- bzw. Bildebene der Abbildungsoptik abgebildet und dort überlagert werden. Im Falle des Doppel-Mikrolinsenarrays zerteilt die Eintrittsseite dieses Mikrolinsenarrays die Intensitätsverteilung in mehrere Teilbereiche. Jedes Mikrolinsenelement der Austrittsseite bildet das entsprechende Segment der Eintrittsseite ins Unendliche ab. Bei sehr vielen Segmenten ergibt sich in Summe im Fernfeld eine homogene Verteilung. Diese homogene Verteilung im Fernfeld wird durch die Abbildungsoptik in die Bildebene transformiert bzw. abgebildet. Dort liegt dann eine homogene Intensitätsverteilung vor. Dieser letztgenannte Aufbau wird in der obigen Veröffentlichung auch als abbildender Homogenisator bezeichnet. Vorteile dieser Anordnung sind eine bessere Kantensteilheit der homogenisierten Verteilung und die Reduktion von Beugungseffekten durch das erste Mikrolinsenarray in der Zielebene.

Weitere Anordnungen zur Homogenisierung von Laserstrahlung sind in

B.Köhler et al: "11 kW direct diode laser system with homogenized 55x20 mm2 Top-Hat intensity distribution",Proceedings of the SPIE, Bd. 6456, 22. Januar 2007, Seiten 64560O-1 bis 64560O-12 und F.Huang et Al: "Laser diode end-pumped efficient coupling system based on microlens arrays",Proceedings of the SPIE, - 2009 Int. Conf. on Optical Instruments and Technology - Optical Systems and Modern Optoelectronic Instruments 2009, Bd. 7506, Seiten 75061E-1 bis 75061E-5, 19. Oktober 2009, offenbart.

Die bekannten optischen Anordnungen zur Homogenisierung von Laserstrahlung erreichen die Homogenisierung jedoch nur in der Bildebene der Abbildungsoptik. Dies führt dazu, dass beispielsweise beim Pumpen eines aktiven Mediums die homogene Verteilung nur in einer Ebene dieses Mediums vorliegt und die Pumplaserstrahlung bei der weiteren Propagation durch das Medium eine deutlich inhomogenere Verteilung aufweisen kann. Dies spielt insbesondere bei Nutzung von Diodenlaserarrays als Laserstrahlquellen eine wichtige Rolle, da dort einzelne Laserdioden der Strahlquelle ausfallen oder degradieren können und damit zu einer inhomogenen Strahlverteilung führen.

Die Aufgabe der vorliegenden Erfindung besteht darin, eine optische Anordnung zum optischen Pumpen eines aktiven Mediums anzugeben, mit der eine Symmetrisierung und/oder Homogenisierung optischer Strahlung einer Lichtquelle nicht nur in einer Ebene erreicht, sondern auch in Ausbreitungsrichtung über eine gewisse Distanz beibehalten wird. Zusätzlich soll der Aufbau möglichst kompakt zu gestalten sein.

### Darstellung der Erfindung

Die Aufgabe wird mit der optischen Anordnung gemäß Patentanspruch 1 gelöst. Vorteilhafte Ausgestaltungen sind Gegenstand der abhängigen Patentansprüche oder lassen sich der nachfolgenden Beschreibung sowie dem Ausführungsbeispiel entnehmen.

Die vorgeschlagene optische Anordnung weist ein aktives Medium sowie eine erste und eine zweite Abbildungsoptik auf, die so hintereinander angeordnet sind, dass ein durch die erste Abbildungsoptik hindurch tretendes paralleles Strahlenbündel zwischen der ersten und der zweiten Abbildungsoptik eine Strahltaille bildet und eine Winkelverteilung des Strahlenbündels im Bereich der Strahltaille durch die zweite Abbildungsoptik auf die Bildebene der zweiten Abbildungsoptik abgebildet wird. Die optische Anordnung zeichnet sich dadurch aus, dass im Bereich der Strahltaille bzw. im Bereich der Brennebene der ersten Abbildungsoptik ein erstes optisches Element zur Homogenisierung der Winkelverteilung der Strahlung, insbesondere mindestens ein erstes Mikrolinsenarray oder Mikrolinsenarray-Paar, angeordnet ist. Im Folgenden wird hierbei auf die Ausgestaltung dieses optischen Elements zur Homogenisierung der Winkelverteilung der Strahlung als Mikrolinsenarray oder Mikrolinsenarray-Paar eingegangen. Dieses optische Element lässt sich jedoch prinzipiell auch in anderer Weise realisieren. So könnten z.B. mehrelementige prismatische Elemente oder beliebig ausgeformte Freiformflächen verwendet werden.

Beim Einsatz der vorgeschlagenen optischen Anordnung muss die einfallende Strahlung nicht zwangsläufig parallel sein, so dass unter Umständen dann auch keine Strahltaille zwischen den beiden Abbildungsoptiken auftritt. Der Bezug auf das parallele Strahlenbündel dient hier lediglich zur Festlegung Parameter der beiden Abbildungsoptiken der optischen Anordnung. Die Strahltaille stellt bei einfallendem parallelen Strahlenbündel den Ort des geringsten Querschnitts des Strahlenbündels zwischen den beiden Abbildungsoptiken dar. Der Bereich der Strahltaille umfasst dabei auch Orte in Strahlrichtung, die um eine geringe Distanz vom Ort des geringsten Querschnitts des Strahlenbündels abweichen können.

Unter der Winkelverteilung der Strahlung wird hierbei die Strahlungsintensität im Fernfeld als Funktion des Winkels verstanden, unter der Ortsverteilung die Verteilung der Strahlungsintensität in einer Ebene senkrecht zur optischen Achse.

Im Fall der nicht-abbildenden Ausführung des ersten Mikrolinsenarrays wird das Strahlenbündel durch das erste Mikrolinsenarray in der Strahltaille der ersten Abbildungsoptik in mehrere Teilstrahlenbündel unterteilt bzw. segmentiert und dadurch im Winkelraum homogenisiert, die durch die zweite Abbildungsoptik in die Bildebene abgebildet werden. Im Fall der abbildenden Ausführung - also eines Mikrolinsenarray-Paars zwischen den Abbildungsoptiken - wird die Strahlung durch das eingangsseitige Mikrolinsenarray des Mikrolinsenarray-Paars unterteilt bzw. segmentiert. Diese Segmente werden dann durch das ausgangsseitige Mikrolinsenarray, bestehend aus je einem zu einem Mikrolinsenelement des eingangsseitigen Mikrolinsenarrays korrespondierenden Mikrolinsenelement, und die zweite Abbildungsoptik in die Brenn- bzw. Bildebene der zweiten Abbildungsoptik abgebildet. Eingangsseitiges und ausgangsseitiges Mikrolinsenarray können selbstverständlich auch getrennt angeordnet sein. Durch diese Anordnung wird eine Symmetrisierung und/oder Homogenisierung der Ortsverteilung der optischen Strahlung in dem Bereich hinter der Bildebene erreicht. Ist die optische Strahlung in der Brennebene der ersten Abbildungsoptik symmetrisch bzw. homogen, was durch die Eigenschaften der Lichtquelle oder - wie in einer weiter unten beschriebenen bevorzugten Ausgestaltung - durch Hinzufügen eines weiteren Mikrolinsenarray(paares) direkt hinter der Lichtquelle erreicht werden kann, dann ist auch die Winkelverteilung in der Brennebene der zweiten Abbildungsoptik symmetrisch bzw. homogen. Dies bedeutet, dass die in der Bildebene vorliegende Intensitätsverteilung auch über eine Strecke in Ausbreitungsrichtung der Strahlung hinter der Bildebene erhalten bleibt und sich lediglich aufgrund der natürlichen Divergenz vergrößert.

Der Erfinder der vorliegenden Anordnung hat erkannt, dass durch eine Symmetrisierung und/oder Homogenisierung der Winkelverteilung der optischen Strahlung die obige Problematik vermieden werden kann. Dadurch ändert sich die Intensitätsverteilung bzw. deren Symmetrie oder Homogenität der optischen Strahlung auch in dem Bereich hinter der Bildebene nicht. Liegt aufgrund der eingesetzten Lichtquelle oder entsprechender zusätzlicher Maßnahmen bereits in der Strahltaille eine in einer Ebene senkrecht zur Strahltaille örtlich homogene Intensitätsverteilung vor, so bleibt die Homogenität der örtlichen Intensitätsverteilung auch im Bereich der Bildebene und dahinter erhalten. Das Gleiche gilt für eine symmetrische örtliche Intensitätsverteilung in der Strahltaille.

Bei den eingesetzten Abbildungsoptiken handelt es sich vorzugsweise um Fokussieroptiken, beispielsweise um Fokussierlinsen oder um Linsengruppen mit einer oder mehreren Fokussierlinsen, wobei die Bildebene dann der Brennebene entspricht.

Wird die vorgeschlagene optische Anordnung mit einem Diodenlaserarray als Lichtquelle eingesetzt, so wird aufgrund der Eigenschaften der Diodenlaserstrahlung auch ohne zusätzliche Maßnahmen eine symmetrische Winkelverteilung erzeugt. Dies kann bereits ausreichen, um beispielsweise beim optischen Pumpen von aktiven Medien nachteilige thermisch induzierte Effekte auf die Strahlqualität zu verhindern.

In einer bevorzugten Ausgestaltung der vorgeschlagenen optischen Anordnung sind in einem Abstand vor der ersten Abbildungsoptik ein zweites Mikrolinsenarray oder Mikrolinsenarray-Paar angeordnet. Dieses Mikrolinsenarray oder Mikrolinsenarray-Paar kann prinzipiell auch durch ein anders ausgestaltetes Element zur Homogenisierung der Winkelverteilung der Strahlung ersetzt sein. Der Abstand des zweiten Mikrolinsenarrays bzw. Mikrolinsenarray-Paars zur ersten Abbildungsoptik ist dabei so gewählt, dass durch das zweite Mikrolinsenarray oder Mikrolinsenarray-Paar geformte Teilstrahlenbündel eines parallelen Eingangsstrahlenbündels durch die erste Abbildungsoptik in der Strahltaille überlagert werden. Hierbei erzeugt das zweite Mikrolinsenarray oder Mikrolinsenarray-Paar eine homogene Intensitätsverteilung auf dem ersten Mikrolinsenarray oder Mikrolinsenarray-Paar und somit eine homogene Winkelverteilung in der Zielebene. Durch dieses zweite Mikrolinsenarray oder Mikrolinsenarray-Paar wird daher eine Homogenisierung der Eingangsstrahlung in der Strahltaille erreicht, wie dies aus dem bereits oben genannten Stand der Technik bekannt ist. Diese Homogenisierung im Ortsraum wird über das erste Mikrolinsenarray oder Mikrolinsenarray-Paar und die zweite Abbildungsoptik zusätzlich im Winkelraum homogenisiert. Der Abstand des zweiten Mikrolinsenarrays bzw. Mikrolinsenarray-Paars zur ersten Abbildungsoptik entspricht dabei vorzugsweise der Brennweite der ersten Abbildungs- bzw. Fokussieroptik. Der Akzeptanzwinkel der Mikrolinsenarrays wird vorzugsweise jeweils gleich dem Divergenzwinkel der fokussierten Strahlung gewählt, so dass kein Verlust an räumlicher Strahlqualität auftritt.

Die Einbringung des zweiten Mikrolinsenarrays bzw. -paares, bspw. kurz hinter der Facettenebene bzw. evtl. vorhandener Kollimationsoptik eines Diodenlaserbarrens, bewirkt, dass die Breite der Intensitätsverteilung in der Brennebene der ersten Abbildungsoptik unabhängig von der Divergenz der Diodenlaserstrahlung die gleiche räumlich Ausdehnung besitzt und damit auch die Divergenz in der Brennebene der zweiten Abbildungsoptik konstant ist, insbesondere unabhängig vom Betriebsstrom der Diodenlaser.

Damit wird mit dieser Ausgestaltung eine Homogenisierung der Eingangsstrahlung sowohl im Orts- als auch im Winkelraum erzielt. Dies ermöglicht insbesondere beim Konzept des Dioden-endgepumpten Slab-Lasers eine symmetrische Verteilung der Pumpleistung und damit auch der Temperatur im aktiven Medium. Durch den Einsatz von Mikrolinsenarrays wird zudem auch ein sehr kompakter Aufbau erhalten. Die vorgeschlagene optische Anordnung ermöglicht dabei eine Pumplichtverteilung, die vollkommen unabhängig von den Eingangsgrößen des hier beispielhaft genannten Diodenlasers bzw. Diodenlaserarrays ist. Die Strahlung kann dabei auf das aktive Medium, beispielsweise einen Laserkristall, mit einer über den gesamten Pumpleistungsbereich konstanten Intensitätsverteilung fokussiert werden. Durch die Homogenisierung von Orts- und Winkelraum wird eine ideale Intensitätsverteilung des Laserlichtes im aktiven Medium bzw. Kristall erzielt. Insbesondere bei größeren Absorptionslängen werden damit durch inhomogene Winkelverteilungen hervorgerufene thermische Effekte vermieden, die ansonsten zu einer Beeinträchtigung der Strahleigenschaften führen können.

Im Falle eines Mikrolinsenarray-Paars sind die beiden Mikrolinsenarrays vorzugsweise so ausgeführt, dass ihre Brennweite gleich ist und in einem Abstand zueinander angeordnet, der der Brennweite dieser Mikrolinsenarrays, d.h. der Brennweiten der Mikrolinsen, entspricht. Vorzugsweise sind beide Mikrolinsenarrays monolithisch integriert, d.h. das Mikrolinsenarray-Paar setzt sich aus einem Substrat zusammen, dessen gegenüberliegende Seiten die beiden Mikrolinsenarrays bilden.

Die beiden Abbildungs- bzw. Fokussieroptiken sind vorzugsweise in einem Abstand zueinander angeordnet, der der Summe ihrer Brennweiten entspricht. Damit wird eine telezentrische Abbildung der Eingangsstrahlverteilung (z.B. Facettenebene der Diodenlaserstrahlung) erreicht. Durch diese telezentrische Anordnung bzw. Abbildung werden relativ scharfe Randbereiche der transformierten Strahlung in der Bildebene der zweiten Abbildungsoptik erhalten. Sind eher unscharfe Randbereiche für die entsprechenden Anwendungen gewünscht oder unkritisch für den konkreten Anwendungsfall, so kann selbstverständlich von einer telezentrischen Anordnung abgewichen werden. Hierdurch kann insbesondere eine weitere Verkürzung der Baulänge erreicht werden.

Die vorgeschlagene Anordnung kann die Symmetrisierung und/oder Homogenisierung bei Verwendung entsprechend rotationssymmetrischer Abbildungsoptiken in beiden Dimensionen senkrecht zur Strahlrichtung erzielen. In zahlreichen Anwendungen ist jedoch eine entsprechende Symmetrisierung und/oder Homogenisierung lediglich in einer Richtung bzw. Achse erforderlich. Dies betrifft beispielsweise den Einsatz eines Diodenlaser-Barrens als Lichtquelle. Hier ist eine Symmetrisierung bzw. Homogenisierung in Richtung der langsamen Achse (slow axis) des Diodenlaser-Barrens erwünscht, während die Intensitätsverteilung in Richtung der schnellen Achse (fast axis) nicht homogenisiert sein muss und beispielsweise ein Gauß-Profil aufweisen kann. In diesem Falle sind die Abbildungsoptiken und Mikrolinsenarrays vorzugsweise als Zylinderlinsen ausgebildet, die die entsprechende Symmetrisierung bzw. Homogenisierung dann lediglich auf der langsamen Achse erzielen.

Hierbei können, wie auch im allgemeinen Fall rotationssymmetrischer Abbildungsoptiken, zusätzliche optische Elemente innerhalb der Anordnung platziert werden, die weitere Funktionen aufweisen, die von der Symmetrisierung bzw. Homogenisierung unabhängig sind. Im Falle der Symmetrisierung bzw. Homogenisierung der Strahlung eines Diodenlaser-Barrens können diese zusätzlichen Elemente beispielsweise Linsen sein, die das Abbildungsverhältnis der schnellen Achse beeinflussen.

Die vorgeschlagene Anordnung lässt sich besonders vorteilhaft zur Homogenisierung und/oder Symmetrisierung der optischen Strahlung einer Laserquelle, insbesondere eines Diodenlaserarrays, einsetzen, mit dem das aktive Medium optisch gepumpt wird.

### Kurze Beschreibung der Zeichnungen

Die vorgeschlagene optische Anordnung wird nachfolgend anhand eines Ausführungsbeispieles in Verbindung mit den Zeichnungen nochmals näher erläutert. Hierbei zeigen:
- Fig. 1.: schematisch ein Beispiel für die optische Anordnung in Draufsicht (auf die Ebene, in der die langsame Achse verläuft);
- Fig. 2: ein Vergleich von Intensitätsverteilungen der optischen Strahlung hinter der Zielebene (Simulation);
- Fig. 3: eine schematische 3-D-Ansicht der optischen Anordnung gemäß Fig. 1;
- Fig. 4: ein Beispiel für die mögliche Positionierung von zusätzlichen Elementen in der Anordnung gemäß Fig. 1; und
- Fig. 5: schematisch ein Beispiel für die optische Anordnung mit aktivem Lasermedium in Draufsicht.

### Wege zur Ausführung der Erfindung

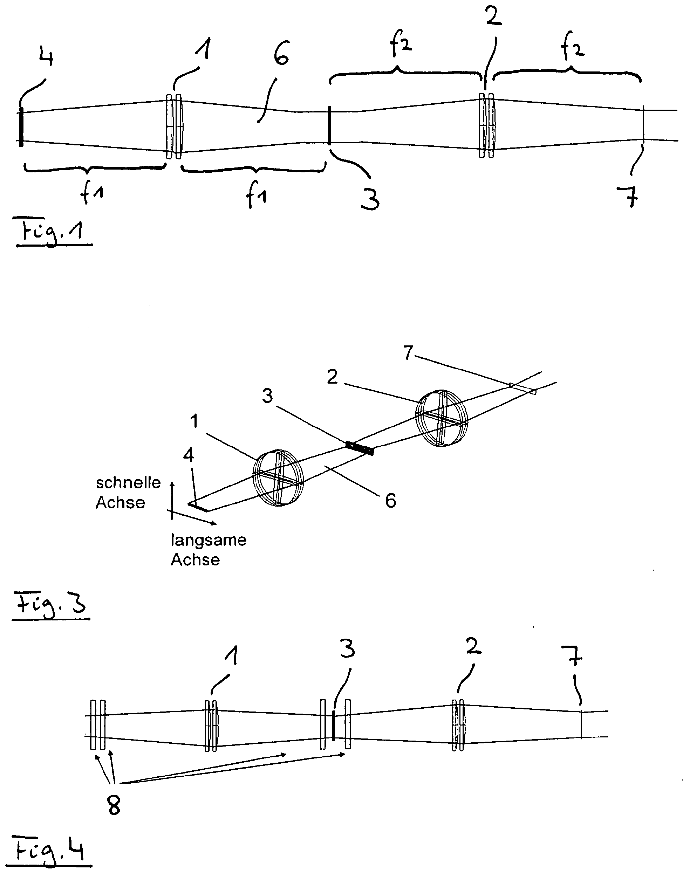

Fig. 1 zeigt schematisch ein Beispiel für die vorgeschlagene Anordnung in Draufsicht. Die Anordnung weist in diesem Beispiel eine erste Fokussieroptik 1 mit einer Brennweite f1 und eine zweite Fokussieroptik 2 mit einer Brennweite f2 auf. Die beiden Fokussieroptiken, in diesem Beispiel Linsengruppen, sind im Abstand f1 + f2 angeordnet. In der Strahltaille zwischen den beiden Fokussieroptiken 1, 2 ist ein Mikrolinsenarray 3 angeordnet. Im Abstand der Brennweite f1 vor der ersten Fokussieroptik 1 befindet sich ein Mikrolinsenarray-Paar 4 im Strahlengang der Eingangsstrahlung. Die beiden Mikrolinsenarrays bzw. Mikrolinsenarray-Paare sind dabei so ausgebildet, dass das durch diese Mikrolinsenarrays bzw. Mikrolinsenarray-Paare hindurch tretende Strahlenbündel 6 in mindestens n = 10 Teilstrahlenbündel aufgeteilt wird. Im Falle der Homogenisierung der Strahlung eines Diodenlaser-Barrens handelt es sich dabei um Mikrolinsenarrays, die eine höhere Anzahl von Mikrolinsen in Richtung der langsamen Achse gegenüber der Richtung der schnellen Achse aufweisen oder bei denen ein derartiger Bereich von der Laserstrahlung durchleuchtet wird. Für diesen Fall zeigt Fig. 1 die Draufsicht in Richtung senkrecht zur langsamen Achse.

Das einfallende Strahlenbündel wird durch das Mikrolinsenarray-Paar 4 in eine Anzahl von Segmenten unterteilt, die mit der Fokussieroptik 1 in der Strahltaille dieser Fokussieroptik überlagert werden. Das Mikrolinsenarray-Paar 4 und die Fokussieroptik 1 erzeugen dabei eine homogene örtliche Intensitätsverteilung in der Ebene der Strahltaille, in der das Mikrolinsenarray 3 angeordnet ist. Dieses Mikrolinsenarray 3 erzeugt wiederum in Kombination mit der Fokussieroptik 2 eine homogene Ortsverteilung in der Zielebene 7, d.h. der Brennebene der Fokussieroptik 2. Im Bereich dieser Zielebene 7 ist das optisch aktive Medium angeordnet, das in der Figur nicht dargestellt ist. Da das Mikrolinsenarray 3 in der rückwärtigen Brennebene der Fokussieroptik 2 liegt, ist auch die Winkelverteilung in der Zielebene homogenisiert.

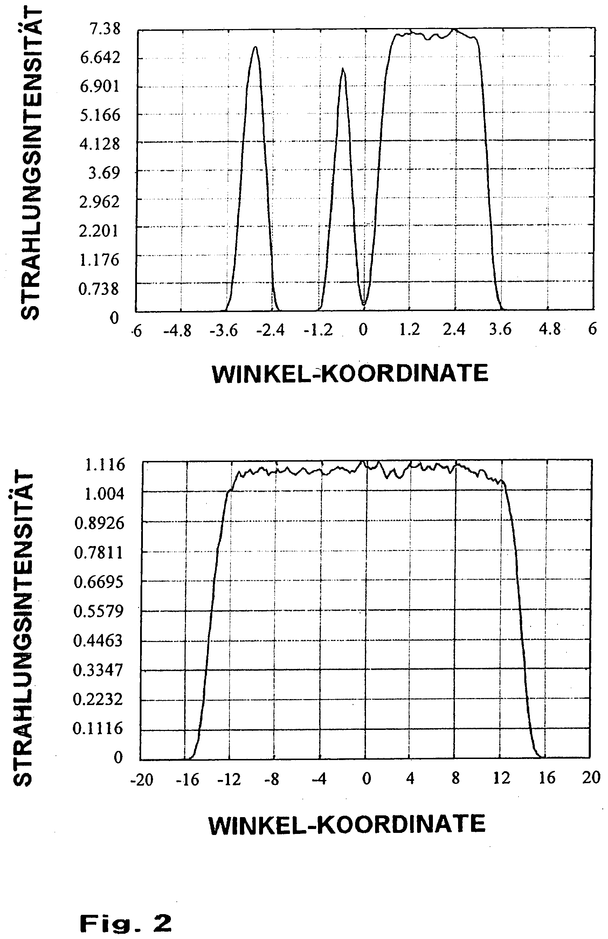

Fig. 2 zeigt in beiden Teilabbildungen eine Ray-Tracing-Simulation der Intensitätsverteilung der optischen Strahlung (Schnitt in der langsamen Achse) hinter der Zielebene. Bei der oberen Teilabbildung wurde eine Anordnung gemäß dem oben beschriebenen Stand der Technik gewählt, die dem abbildenden Homogenisator entspricht. Hier wurde lediglich ein Mikrolinsenarray-Paar vor einer Fokussieroptik eingesetzt, durch die die Homogenisierung in der Zielebene erreicht wird. In der unteren Teilabbildung wird das Ergebnis bei der Verwendung der Anordnung gemäß Fig. 1 dargestellt. In beiden Fällen wurde im Eingangsstrahlenbündel ein Teilbereich ausgeblendet, um eine Inhomogenität der Eingangsstrahlung zu erreichen, wie sie beispielsweise bei Ausfall eines Diodenlasers eines Diodenlaserarrays auftreten kann. Während die Intensitätsverteilung bei beiden Anordnungen in der Zielebene homogen ist, ergibt sich in einer Ebene hinter der Zielebene im Fall der Anordnung des Standes der Technik eine deutlich inhomogene Intensitätsverteilung. Die mit der vorgeschlagenen Anordnung erzeugte Intensitätsverteilung ist aufgrund der hier zusätzlich erreichten Homogenisierung bzw. Symmetrisierung der Winkelverteilung jedoch noch immer homogen.

Fig. 3 zeigt stark schematisiert eine 3D-Ansicht einer Anordnung gemäß Fig. 1 bei Einsatz mit einem Diodenlaser-Barren, bei der die Homogenisierung lediglich in Richtung der langsamen Achse der Diodenlaserquelle durchgeführt wird. Die gleichen Bezugszeichen bezeichnen dabei wieder die gleichen Elemente wie die der Figur 1.

Zusätzlich können weitere Elemente im Strahlengang platziert werden, die auf die gewünschte Homogenisierung bzw. Symmetrisierung der vorgeschlagenen Anordnung keinen Einfluss haben. Fig. 4 zeigt hierzubeispielhaft mögliche Positionen 8 für Zylinderlinsen zur Veränderung des Abbildungsverhältnisses in der schnellen Achse bei Einsatz eines Diodenlaser-Barrens als Lichtquelle. Die unterschiedlichen Positionen 8 für derartige Zylinderlinsen sind durch entsprechende Elemente in Figur 4 veranschaulicht, die wiederum eine Draufsicht auf die optische Anordnung darstellt. Auch hier ist das nicht dargestellte aktive Medium, das mit der homogenisierten bzw. symmetrisierten Laserstrahlung gepumpt wird, im Bereich der Ziel- bzw. Brennebene 7 angeordnet.

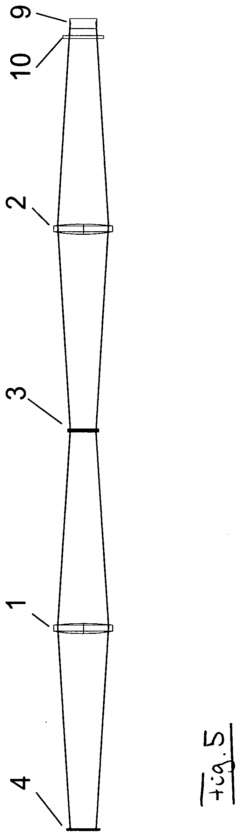

Figur 5 zeigt schließlich ein Beispiel für einen Aufbau der Anordnung der Figur 1, bei der das aktive Lasermedium 9 in der Zielebene dargestellt ist. Das aktive Lasermedium 9 ist in einem Resonator angeordnet, von dem einer der Endspiegel, ein dichroitischer Spiegel 10, in der Figur zu erkennen ist. Das optische Pumpen des aktiven Lasermediums 9 erfolgt durch diesen Spiegel hindurch, der für die Wellenlänge des Pumplasers durchlässig, für die Wellenlänge der von dem aktiven Medium 9 erzeugten Laserstrahlung jedoch hoch reflektierend ist. Der dichroitische Spiegel 10 kann auch als Beschichtung auf dem aktiven Lasermedium 9 realisiert sein.

Mit der vorgeschlagenen optischen Anordnung lässt sich eine Symmetrisierung und/oder Homogenisierung der Winkelverteilung der optischen Strahlung zum optischen Pumpen eines Lasermediums erreichen. In Verbindung mit einer Homogenisierung im Ortsraum kann damit ein homogenisiertes annähernd linienförmiges oder auch ein homogenisiertes rotationssymmetrisches Strahlprofil im Sinne einer Top-Hat-Verteilung erreicht werden. Die Winkelverteilung in der Zielebene ist symmetrisch, wenn die Intensitätsverteilung in der Ebene der rückwärtigen Brennebene der zweiten Abbildungsoptik symmetrisch ist. Insbesondere bei Verwendung der optischen Anordnung in Verbindung mit einer Pumpoptik ist die Symmetrie und/oder Homogenität der Winkelverteilung von großem Interesse und vorteilhaft zur Verhinderung unsymmetrischer thermischer Linseneffekte. Die homogene Verteilung wird dabei auch unabhängig vom Ausfall einzelner Emitter erreicht, beispielsweise bei Einsatz eines Diodenlaserarrays als Strahlquelle.

Als Abbildungsoptiken können in bekannter Weise Linsen oder auch reflektierende Elemente eingesetzt werden. Weiterhin ist es selbstverständlich möglich, durch zusätzliche reflektierende Elemente, wie beispielsweise Spiegel, den Strahlengang zu falten und damit eine noch kompaktere Anordnung zu erzielen.

### Bezugszeichenliste

- 1: erste Fokussieroptik
- 2: zweite Fokussieroptik
- 3: erstes Mikrolinsenarray
- 4: zweites Mikrolinsenarray bzw. Mikrolinsenarray-Paar
- 6: Strahlenbündel
- 7: Zielebene/Brennebene
- 8: Positionen zusätzlicher Elemente
- 9: aktives Lasermedium
- 10: dichroitischer Spiegel

## Patentansprüche

1. Optische Anordnung zum optischen Pumpen eines aktiven Mediums (9), mit einer ersten (1) und einer zweiten Abbildungsoptik (2) sowie dem aktiven Medium (9), die so hintereinander angeordnet sind, dass ein durch die erste Abbildungsoptik (1) hindurch tretendes paralleles Strahlenbündel zwischen der ersten (1) und der zweiten Abbildungsoptik (2) eine Strahltaille bildet und eine Winkelverteilung des Strahlenbündels im Bereich der Strahltaille durch die zweite Abbildungsoptik (2) auf eine Bildebene der zweiten Abbildungsoptik (2) abgebildet wird,
wobei im Bereich der Strahltaille ein erstes optisches Element, das eine Homogenisierung der Winkelverteilung der Strahlung vor der zweiten Abbildungsoptik erzielt, angeordnet ist.

2. Optische Anordnung nach Anspruch 1,
**dadurch gekennzeichnet,**
**dass** das erste optische Element zur Homogenisierung der Winkelverteilung der Strahlung durch ein erstes Mikrolinsenarray (3) oder Mikrolinsenarray-Paar gebildet ist.

3. Optische Anordnung nach Anspruch 1 oder 2,
**dadurch gekennzeichnet,**
**dass** in einem Abstand vor der ersten Abbildungsoptik (1) ein zweites optisches Element, das eine Homogenisierung der Winkelverteilung der Strahlung vor der ersten Abbildungsoptik (1) erzielt, angeordnet ist, wobei die durch das zweite optische Element erhaltene homogene Winkelverteilung durch die erste Abbildungsoptik (1) in die Strahltaille abgebildet wird.

4. Optische Anordnung nach Anspruch 1 oder 2,
**dadurch gekennzeichnet,**
**dass** in einem Abstand vor der ersten Abbildungsoptik (1) ein zweites Mikrolinsenarray oder ein Mikrolinsenarray-Paar (4) angeordnet ist, wobei der Abstand so gewählt ist, dass das durch das zweite Mikrolinsenarray oder Mikrolinsenarray-Paar (4) geformte Teilstrahlenbündel eines parallelen Eingangsstrahlenbündels durch die erste Abbildungsoptik (1) in der Strahltaille überlagert werden.

5. Optische Anordnung nach Anspruch 4,
**dadurch gekennzeichnet,**
**dass** das Mikrolinsenarray-Paar (4) zwei zweite Mikrolinsenarrays mit gleicher Brennweite in einem Abstand umfasst, der der Brennweite der zweiten Mikrolinsenarrays entspricht.

6. Optische Anordnung nach einem der Ansprüche 1 bis 5, **dadurch gekennzeichnet,**
**dass** die beiden Abbildungsoptiken (1, 2) Fokussieroptiken sind, die in einem Abstand zueinander angeordnet sind, der einer Summe ihrer Brennweiten entspricht.

7. Optische Anordnung nach einem der Ansprüche 1 bis 6, **dadurch gekennzeichnet,**
**dass** die beiden Abbildungsoptiken (1, 2) Zylinderlinsen oder Gruppen von Zylinderlinsen enthalten.

8. Optische Anordnung nach einem der Ansprüche 1 bis 7, **dadurch gekennzeichnet,**
**dass** eine Laserquelle, insbesondere ein Diodenlaserarray oder Diodenlaserbarren, mit einer Kollimationsoptik vor der ersten Abbildungsoptik (1) oder dem zweiten optischen Element oder dem zweiten Mikrolinsenarray oder Mikrolinsenarray-Paar (4) angeordnet ist.

## Claims

1. Optical arrangement for optically pumping an active medium (9), with a first (1) and a second imaging optical system (2) and the active medium (9), which are arranged one behind the other in such manner that a parallel beam bundle passing through the first imaging optical system (1) forms a beam waist between the first (1) and the second imaging optical system (2), and an angular distribution of the beam bundle in the region of the beam waist is projected onto an image plane of the second imaging optical system (2) by the second imaging optical system (2), wherein a first optical element that achieves a homogenization of the angular distribution of the radiation before the second imaging optical system is arranged in the region of the beam waist.

2. Optical arrangement according to Claim 1, **characterized in that** the first optical element for homogenizing the angular distribution of the radiation is formed by a first microlens array (3) or microlens array pair.

3. Optical arrangement according to Claim 1 or 2, **characterized in that** a second optical element that achieves a homogenization of the angular distribution of the radiation before the first imaging optical system (1) is arranged at a distance in front of the first imaging optical system (1), wherein the homogeneous angular distribution achieved by the second optical element is projected into the beam waist by the first imaging optical system (1).

4. Optical arrangement according to Claim 1 or 2, **characterized in that** a second microlens array or microlens array pair (4) is arranged at a distance in front of the first imaging optical system (1), wherein the distance is chosen such that the partial beam bundle formed of a parallel incoming beam bundle by the second microlens array or microlens array pair (4) is superposed in the beam waist by the first imaging optical system (1).

5. Optical arrangement according to Claim 4, **characterized in that** the microlens array pair (4) comprises two second microlens arrays having the same focal length at a distance corresponding to the focal length of the second microlens arrays.

6. Optical arrangement according to any one of Claims 1 to 5, **characterized in that** that the two imaging optical systems (1, 2) are focusing optical systems that are disposed at a distance from one another corresponding to a sum of their focal lengths.

7. Optical arrangement according to any one of Claims 1 to 6, **characterized in that** both imaging optical systems (1, 2) contain cylinder lenses or groups of cylinder lenses.

8. Optical arrangement according to any one of Claims 1 to 7, **characterized in that** a laser source, particularly a laser diode array or laser diode bar, with a collimation optics is arranged in front of the first imaging optical system (1) or the second optical element or the second microlens array or microlens array pair (4) .

## Revendications

1. Dispositif optique pour le pompage optique d'un milieu actif (9), comportant une première (1) et une deuxième optique d'imagerie (2) ainsi que le milieu actif, qui sont disposés l'un derrière l'autre de telle sorte qu'un faisceau de rayons parallèles entrant à travers la première optique d'imagerie (1) forme un rétrécissement de faisceau entre la première (1) et la deuxième optique d'imagerie (2) et une distribution angulaire du faisceau de rayons au niveau du rétrécissement de faisceau est imagée par la deuxième optique d'imagerie (2) sur un plan d'image de la deuxième optique d'imagerie (2), dans lequel au niveau du rétrécissement de faisceau un premier élément optique est disposé, qui produit une homogénéisation de la distribution angulaire du rayon avant la deuxième optique d'imagerie.

2. Dispositif optique selon la revendication 1, **caractérisé en ce que** le premier élément optique pour l'homogénéisation de la distribution angulaire du rayonnement est formé par un premier réseau de micro lentilles (3) ou une paire de réseau de micro lentilles.

3. Dispositif optique selon la revendication 1 ou 2, **caractérisé en ce que** dans un espacement à l'avant de la première optique d'imagerie, un deuxième élément optique, qui produit une homogénéisation de la distribution angulaire du rayonnement avant la première optique d'imagerie, est disposé, dans lequel la distribution angulaire homogène obtenue par le deuxième élément optique est imagée dans la rétrécissement de faisceau par la première optique d'imagerie (1).

4. Dispositif optique selon la revendication 1 ou 2, **caractérisé en ce que** dans un espacement avant la première optique d'imagerie (1), un deuxième réseau de micro lentilles ou une paire de réseau de micro lentilles (4) est disposé, dans lequel l'espacement est choisi de telle sorte que le faisceau de rayons partiels formé par le deuxième réseau de micro lentilles ou la paire de réseaux de micro lentilles (4) d'un faisceau de rayons d'entrée parallèle est superposé dans la rétrécissement de faisceau par l'intermédiaire de la première optique d'imagerie (1).

5. Dispositif optique selon la revendication 4, **caractérisé en ce que** la paire de réseaux de micro lentilles (4) comprend deux deuxièmes réseaux de micro lentilles avec la même distance focale dans un espacement, qui correspond à la distance focale du deuxième réseau de micro lentilles.

6. Dispositif optique selon une des revendications 1 à 5, **caractérisé en ce que** les deux optiques d'imagerie (1,2) sont des optiques de focalisation, qui sont disposées en un espacement l'une par rapport à l'autre, qui correspond à une somme de leur distance focale.

7. Dispositif optique selon une des revendications 1 à 6, **caractérisé en ce que** les deux optiques d'imagerie (1,2) contiennent des lentilles cylindriques ou des groupes de lentilles cylindriques.

8. Dispositif optique selon une des revendications 1 à 7, **caractérisé en ce que** une source de laser, notamment un réseau de lasers à diodes ou des barres de lasers à diodes, est disposée avec une optique de collimation avant la première optique d'imagerie (1) ou le deuxième élément optique ou le deuxième réseau de micro lentilles ou la paire de réseaux de micro lentilles (4).
